# EUROPÄISCHE PATENTSCHRIFT

(11) **EP 2 891 397 B1**
(45) Veröffentlichungstag und Bekanntmachung des Hinweises auf die Patenterteilung: **17.10.2018**
(21) Anmeldenummer: 13759432.1
(22) Anmeldetag: 23.08.2013
(51) Int. Cl.: H05K 7/20

(54) **WÄRMETAUSCHER FÜR DIE SCHALTSCHRANKKÜHLUNG UND EINE ENTSPRECHENDE KÜHLANORDNUNG**
HEAT EXCHANGER FOR COOLING A SWITCH CABINET AND CORRESPONDING COOLING ARRANGEMENT
ÉCHANGEUR DE CHALEUR POUR REFROIDISSEMENT D'ARMOIRES DE COMMANDE, ET SYSTÈME DE REFROIDISSEMENT CORRESPONDANT

(30) Priorität: 31.08.2012 DE 102012108109
(43) Veröffentlichungstag der Anmeldung: 08.07.2015
(73) Patentinhaber: RITTAL GmbH & Co. KG, 35745 Herborn (DE)
(72) Erfinder: CACHO ALONSO, Juan, Carlos, 35745 Herborn (DE)
(74) Vertreter: Angerhausen, Christoph
(86) Internationale Anmeldenummer: PCT/DE2013/100306
(87) Internationale Veröffentlichungsnummer: WO 2014/032654

(56) Entgegenhaltungen:
- DE-A1- 2 423 440
- DE-A1-102008 049 896
- DE-A1-102010 009 776
- JP-A- S62 252 889
- US-A- 6 053 238
- US-A1- 2002 014 324

## Beschreibung

Die Erfindung betrifft eine Kühlanordnung für die Schaltschrankkühlung. Eine gattungsgemäße Kühlanordnung weist einen Schaltschrank und einem Kühlgerät auf, das einen ersten und einen zweiten Wärmetauscher für die Schaltschrankkühlung aufweist, der ein erstes Leitungssystem für ein erstes Kühlmittel und mindestens ein von dem ersten Leitungssystem fluidisch abgetrennten zweites Leitungssystem für ein zweites Kühlmittel aufweist, wobei das erste und das zweite Leitungssystem thermisch miteinander gekoppelt sind, wobei der Wärmetauscher eine Mehrzahl Lamellen aufweist, wobei benachbarte Lamellen zwischen sich einen Luftströmungskanal durch den Wärmetauscher ausbilden, und wobei das erste und das zweite Leitungssystem über die Mehrzahl Lamellen thermisch miteinander gekoppelt sind.

Aus der DE 200 08 411 U1 ist ein Aggregatschrank für eine Druckmaschine bekannt, der eine Kühlanordnung mit den zuvor genannten Merkmalen aufweist. Ähnliche Kühlanordnungen beschreiben auch die DE 10 2007 054 724 A1, die DE 10 2008 059 023 A1, die US 6,053,238 A und die US 6,039,111 A.

Bei der Schaltschrankkühlung ist es ein fortwährendes Problem, dass die Umgebungstemperaturen des Schaltschranks über den Jahresverlauf sowie die Verlustleistungen und die damit einhergehende Abwärme der in dem Schaltschrank aufgenommenen Komponenten starken Schwankungen ausgesetzt sein können, wobei unabhängig von diesen Schwankungen die im Schaltschrankinnenraum vorherrschende Lufttemperatur unterhalb eines bestimmten Wertes gehalten werden muss, um zu vermeiden, dass die in dem Schaltschrank aufgenommenen Komponenten Schaden nehmen. Die für die Schaltschrankkühlung verwendeten Kühlgeräte, seien es passive oder aktive Geräte, weisen jedoch stets einen schmalen Kühlleistungsbereich auf, in welchem sie energieeffizient arbeiten können. Verdichter getriebene Kühlgeräte arbeiten beispielsweise im Dauerbetrieb am energieeffizientesten. Die im Dauerbetrieb erzielbare maximale Kühlleistung des Verdichter getriebenen Kühlkreislaufes muss jedoch an maximale Umgebungstemperaturen und maximale Verlustleistungen der in dem Schaltschrank aufgenommenen Komponenten angepasst sein, damit auch in Extremsituationen eine ausreichende Kühlung gewährleistet werden kann. Dies hat zur Folge, dass der Verdichter getriebene Kühlkreislauf über den Jahresverlauf stets im An-Aus-Betrieb läuft, mit den entsprechenden Nachteilen hinsichtlich des Energieverbrauchs.

Grundsätzlich ist es zur Steigerung der Energieeffizienz des Kühlgeräts wünschenswert, dass die Zeitdauer, in welcher der Verdichter getriebene Kühlkreislauf in Betrieb ist, so kurz wie möglich gehalten wird.

Um diesem Problem zu begegnen, sind aus dem Stand der Technik kombinierte Kühlgeräte bekannt, welche zusätzlich zu einem aktiven Kühlkreislauf, wie einem Verdichter getriebenen Kühlkreislauf oder einem Kaltwassersatz, einen passiven Kühlkreislauf oder ein passives Kühlelement, beispielsweise in Form eines Luft-Luft-Wärmetauschers, aufweisen. Solche Kühlgeräte werden im weiteren Verlauf der Anmeldung auch als "Hybridkühlgeräte" bezeichnet. Aktive Kühlkreisläufe weisen eine Kältemaschine oder eine Kaltwassersatz auf, die Kälte in das System einbringen und in der Regel zur Kühlung eines Kühlmediums dienen. Die Kältemaschine kann beispielsweise einen Verdichter aufweisen. Der Kaltwassersatz kann im einfachsten Fall ein Kaltwasserreservoir aufweisen, wobei der Fachmann verstehen wird, dass "Wasser" bei Kühlanwendungen nicht beschränkend auszulegen ist, sondern lediglich als Synonym für die aus dem Stand der Technik bekannten Kühl- oder Kältemittel, allgemein als "Kühlmedium" bezeichnet, verwendet wird. Passive Kühlkreisläufe weisen dementsprechend keine Kältemaschine oder Kaltwasserquelle auf. Es erfolgt keine aktive Kühlung eines Kühlmediums.

Diese Kühlgeräte sind derart ausgelegt, dass über einen möglichst breiten Umgebungstemperaturbereich des Schaltschranks sowie für möglichst hohe Verlustleistungen der in dem Schaltschrank aufgenommenen Komponenten allein passiv über den Luft-Luft-Wärmetauscher die notwendige Kühlung des Schaltschrankinnenraums bereit gestellt werden kann, so dass der aktive Kühlkreislauf, also beispielsweise der Verdichter getriebene Kühlkreislauf nur dann unterstützend in Betrieb genommen werden muss, wenn die mit Hilfe des Luft-Luft-Wärmetauschers erzielbare Kühlleistung nicht ausreicht.

Dadurch bedingt, dass sich der strukturelle Aufbau eines Kühlgeräts, das auf einem Luft-Luft-Wärmetauscher basiert, von dem eines Kühlgeräts, das auf einem Verdichter getriebenen Kühlkreislauf basiert, grundsätzlich unterscheidet, ist es bei den aus dem Stand der Technik bekannten Kühlgeräten bisher nicht, oder nur unter hohem Aufwand möglich, dass der auf dem Luft-Luft-Wärmetauscher basierende Kühlkreislauf parallel zu dem Verdichter getriebenen Kühlkreislauf betrieben wird. Darüber hinaus ist es bei den bekannten Kühlgeräten für die Umschaltung zwischen den genannten Kühlprozessen stets notwendig, dass strukturelle Änderungen im Inneren des Kühlgeräts vorgenommen werden müssen. Beispielsweise muss die Luftführung durch das Umschwenken von Klappen und dergleichen an den gewünschten Kühlprozess angepasst werden. Dies erfordert entsprechende Stellmechanismen und die Verwendung von Stellmotoren, welche die Zuverlässigkeit des Systems herabsetzen und dessen Komplexität erhöhen. Dies ist insbesondere vor dem Hintergrund kritisch, dass der Ausfall des Kühlgeräts dazu führen kann, dass das System aus elektronischen Komponenten, welches in dem Schaltschrankinnenraum aufgenommen ist, ausfällt oder sogar zerstört wird.

Es ist daher die Aufgabe der Erfindung, einen Wärmetauscher für die Schaltschrankkühlung und einen entsprechenden Schaltschrank bereit zu stellen, welche die energieeffiziente und sichere Kühlung des Schaltschranks gewährleisten, wobei diese darüber hinaus die besonders flexible Anpassung des Kühlgeräts an die individuellen Gegebenheiten, wie Verlustleistung der Schaltschrankkomponenten und Umgebungstemperatur des Schaltschranks, ermöglichen sollen.

Diese Aufgabe wird erfindungsgemäß durch eine Kühlanordnung mit den Merkmalen des Anspruchs 1 sowie durch eine Kühlanordnung mit den Merkmalen des Anspruchs 8 gelöst. Die verbleibenden abhängigen Ansprüche betreffen jeweils vorteilhafte Ausführungsformen der Erfindung.

Erfindungsgemäß ist der erste Wärmetauscher in einem ersten Luftgang mit einem ersten Lufteinlass und einem ersten Luftauslass, die zur Umgebung des Schaltschranks hin geöffnet sind, und der zweite Wärmetauscher in einem zweiten Luftgang mit einem zweiten Lufteinlass und einem zweiten Luftauslass, die zu einem Innenraum des Schaltschranks hin geöffnet sind, angeordnet, wobei das erste Leitungssystem des ersten Wärmetauschers mit dem ersten Leitungssystem des zweiten Wärmetauschers einen ersten geschlossenen Kühlmittelkreislauf und das zweite Leitungssystem des ersten Wärmetauschers mit dem zweiten Leitungssystem des zweiten Wärmetauschers einen zweiten geschlossenen Kühlmittelkreislauf bildet, wobei einer der Kühlmittelkreisläufe ein aktiver Kühlkreislauf und der andere Kühlmittelkreislauf ein passiver Kühlkreislauf ist. Der erfindungsgemäße Wärmetauscher ist daher prinzipiell ein luftgekühlter Lamellenwärmetauscher, der den Wärmeaustausch zwischen der ihn durchströmenden Luft und einem Kühlmittel des ersten und/oder einem weiteren Kühlmittel des zweiten Leitungssystems ermöglicht. Der erfindungsgemäße Wärmetauscher zeichnet sich auch gerade dadurch aus, dass er, wenn er für den Aufbau eines Kühlgeräts für die Schaltschrankkühlung verwendet wird, eine hohe Variabilität hinsichtlich des realisierten Kühlprozesses bietet. Grundsätzlich ist der erfindungsgemäße Wärmetauscher jedoch nicht
auf Schaltschrankkühlanwendungen beschränkt, vielmehr kann er in unterschiedlichsten industriellen Kühlanwendungen oder auch in Haushalt Verwendung finden.

Vorzugsweise sind das erste und das zweite Leitungssystem in Luftströmungsrichtung durch den Wärmetauscher hintereinander angeordnet. Ist eines der beiden Leitungssysteme Bestandteil eines passiven Kühlsystems und das andere Leitungssystem Bestandteil eines aktiven Kühlsystems, ist es zweckmäßig, dass das Leitungssystem des passiven Kühlkreislaufes in Luftströmungsrichtung vor dem Leitungssystem des aktiven Kühlkreislaufes angeordnet ist.

Der erfindungsgemäße Wärmetauscher soll ein modulares Bauteil sein, welches dazu dienen kann, in ein und derselben Ausführungsform für die Ausgestaltung unterschiedlichster Kühlgeräte für die Schaltschrankklimatisierung zu dienen. Um seine flexible Integration in ein Schaltschrankkühlgerät zu ermöglichen, ist bei einer Ausführungsform der Erfindung vorgesehen, dass das erste und das zweite Leitungssystem jeweils einen Anschluss für einen Kühlmittelvorlauf und einen Anschluss für einen Kühlmittelrücklauf aufweist.

Bei einer Ausführungsform der Erfindung ist das Kühlgerät ein an einer vertikalen Wand des Schaltschranks befestigtes Wandkühlgerät. Dabei ist vorzugsweise der erste Wärmetauscher zumindest teilweise oberhalb des zweiten Wärmetauschers angeordnet, wobei mindestens einer der beiden Kühlmittelkreisläufe ein passiver ist. Wenn die Wärmetauscher wie zuvor beschrieben angeordnet sind und einer der beiden Kühlmittelkreisläufe ein geschlossener, passiver ist, wird bei Schaltschranktemperaturen, die oberhalb der Umgebungstemperatur des Schaltschrankes liegen, wenn der passive Kühlmittelkreislauf zumindest teilweise mit einem Kühlmittel gefüllt ist, das in dem passiven Kühlmittelkreislauf im Bereich des zweiten Wärmetauschers vorgehaltene Kühlmittel aufgrund der Schaltschrankluftwärme vom flüssigen in den gasförmigen Aggregatzustand übergehen, in den ersten Wärmetauscher aufsteigen, dort von der kühleren Umgebungsluft abgekühlt werden und somit kondensieren, um daraufhin schwerkraftgetrieben wieder in den zweiten Wärmetauscher zurückzufließen.

Während das Kühlmittel beim Verdampfen im zweiten Wärmetauscher Wärme aufnimmt, gibt es dieselbe Wärmemenge beim Kondensieren im ersten Wärmetauscher wieder ab. Diese Wärmemenge entzieht das Kühlmittel im zweiten Wärmetauscher gerade der den zweiten Wärmetauscher durchströmenden Schaltschrankluft und gibt sie beim Kondensieren im ersten Wärmetauscher an die Umgebungsluft ab. Es findet somit ein Nettowärmefluss von dem zweiten Luftgang in den ersten Luftgang statt.

Der erste Wärmetauscher ist in dem ersten Luftgang und der zweite Wärmetauscher ist in dem zweiten Luftgang derart angeordnet, dass das Leitungssystem des passiven Kühlmittelkreislaufes in Luftströmungsrichtung vor dem Leitungssystem des aktiven Kühlmittelkreislaufes angeordnet ist. Der aktive Kühlmittelkreislauf kann dabei vielfältig ausgestaltet sein. Er kann beispielsweise ein Verdichterkreislauf sein, mit einem Verdichter, einem Verflüssiger, einem Expansionsventil und einem Verdampfer, wobei der Verflüssiger und der Verdampfer gerade durch den ersten und den zweiten Wärmetauscher bereitgestellt werden. Er kann jedoch auch ein Kaltwasserkreislauf sein, bei dem der Wärmetransport über die Zirkulation eines flüssigen Kühlmittels, vorzugsweise Wasser, erfolgt. Das den zweiten Wärmetauscher in dem zweiten Luftgang durchströmende Flüssigkühlmittel kann dabei mit Hilfe einer externen Kaltwasserquelle oder über den in dem ersten Luftgang angeordneten ersten Wärmetauscher bereitgestellt sein.

Ein alternativer erfindungsgemäßer Schaltschrank weist einen ersten und einen zweiten erfindungsgemäßen Wärmetauscher auf, wobei wiederum der erste Wärmetauscher in einem ersten Luftgang mit einem ersten Lufteinlass und einem ersten Luftauslass, die zur Umgebung des Schaltschranks hin geöffnet sind, und der zweite Wärmetauscher in einem zweiten Luftgang mit einem zweiten Luftgang mit einem zweiten Lufteinlass und einem zweiten Luftauslass, die zu einem Innenraum des Schaltschranks hin geöffnet sind, angeordnet ist, wobei entweder:
1. das erste und das zweite Leitungssystem des ersten Wärmetauschers derart in Reihe geschaltet sind, dass der erste Wärmetauscher (1.1) einen Anschluss für einen Kühlmittelvorlauf und einen Anschluss für einen Kühlmittelrücklauf aufweist, die in Reihe geschalteten Leitungssystem entweder mit dem ersten oder dem zweiten Leitungssystem des zweiten Wärmetauschers einen geschlossenen Kühlmittelkreislauf bilden, und wobei das Leitungssystem des zweiten Wärmetauschers, welches nicht Bestandteil des geschlossenen Kühlmittelkreislaufes ist, von einem Kühlmittel durchströmt ist; oder
2. das erste und das zweite Leitungssystem des zweiten Wärmetauschers derart in Reihe geschaltet sind, dass der zweite Wärmetauscher (1.2) einen Anschluss für einen Kühlmittelvorlauf und einen Anschluss für einen Kühlmittelrücklauf aufweist, wobei die in Reihe geschalteten Leitungssysteme entweder mit dem ersten oder dem zweiten Leitungssystem des ersten Wärmetauschers einen geschlossenen Kühlmittelkreislauf bilden, und wobei das Leitungssystem des ersten Wärmetauschers, welches nicht Bestandteil des geschlossenen Kühlmittelkreislaufes ist, von einem Kühlmittel durchströmt ist,
wobei der geschlossene Kühlmittelkreislauf ein passiver und das von dem Kühlmittel durchströmte Leitungssystem ein aktiver, vorzugsweise Pumpen- oder Verdichter getriebener Kühlkreislauf ist.

Dabei kann vorgesehen sein, dass der erste Wärmetauscher zumindest teilweise oberhalb des zweiten Wärmetauschers angeordnet ist.

Bei einer weiteren Ausführungsform der Erfindung ist der Wärmetauscher, der das von dem Kühlmittel durchströmte Leitungssystem aufweist, ein Verdampfer oder ein Luft-Wasser-Wärmetauscher des aktiven Kühlkreislaufes und zugleich, wenn das von dem Kühlmittel durchströmte Leitungssystem Bestandteil des ersten Wärmetauschers ist, ein Verflüssiger des passiven Kühlkreislaufes, oder, wenn das von dem Kühlmittel durchströmte Leitungssystem Bestandteil des zweiten Wärmetauschers ist, ein Verdampfer des passiven Kühlkreislaufes.

Bei einer Ausführungsform der Erfindung ist einer der Kühlmittelkreisläufe ein passiver und der andere ein verdichtergetriebener Kühlmittelkreislauf, wobei ein Verdichter und ein Expansionsmittel des aktiven Kühlmittelkreislaufes jeweils entweder über eine wahlweise öffen- und verschließbare Bypassleitung überbrückt, oder können einen Zustand einnehmen, in welchem ein Kühlmittelsieb im Wesentlichen ohne Druckverlust passieren kann. Bei dieser Ausfuhrungsform weist das Hybridkühlgerät vier unterschiedliche Betriebsmodi auf. In einem ersten Betriebsmodus wird der erste Kühlmittelkreislauf aktiv betrieben und der zweite Kühlmittelkreislauf ist deaktiviert. In einem zweiten Betriebsmodus wird der erste Kühlmittelkreislauf passiv betrieben und der zweite Kühlmittelkreislauf ist deaktiviert. In einem dritten Betriebsmodus wird der erste Kühlmittelkreislauf aktiv und der zweite Kühlmittelkreislauf passiv betrieben. In einem vierten Betriebsmodus wird sowohl der erste als auch der zweite Kühlmittelkreislauf passiv betrieben. Der erste Kühlmittelkreislauf muss somit nur dann aktiv betrieben werden, wenn die Summe aus den Kühlleistungen des ersten und des zweiten Kühlmittelkreislaufes, wenn neben dem zweiten auch der erste Kühlmittelkreislauf passiv betrieben wird, nicht ausreicht.

Anstelle der Bypassleitungen kann auch vorgesehen sein, dass das Expansionsmittel bzw. der Verdichter einen Zustand einnehmen können, in welchem sie das Kühlmittel im Wesentlichen ohne Druckverlust passieren lassen. So kann bei Expansionsmitteln, welche beispielsweise als Expansionsventile mit einem Nadelventil ausgebildet sind, das Ventil in eine Offenstellung gebracht werden, in welcher das Kühlmittel das Expansionsventil im Wesentlichen ungehindert passieren kann. Ebenso ist es denkbar, dass der Verdichter entweder eine integrierte Bypassleitung aufweist oder eine Betriebsstellung einnehmen kann, in welche das Kühlmittel ihn ungehindert passieren kann.

Weitere Einzelheiten der Erfindung werden anhand der nachstehenden Figuren erläutert. Dabei zeigt:
- Figur 1: eine Ausführungsform des erfindungsgemäßen Wärmetauschers, bei dem, zur besseren Veranschaulichung, die Lamellen teilweise weggelassen worden sind;
- Figur 2: eine schematische Querschnittsansicht eines Hybridkühlgeräts für den Wandaufbau, das eine Heatpipe mit einem Verdichter getriebenen Kühlkreislauf kombiniert;
- Figur 3: ein Kühlgerät, das ausschließlich eine Heatpipe aufweist und nicht Teil der Erfindung ist;
- Figur 4: ein erfindungsgemäßes Hybridkühlgerät, das einen Kaltwassersatz im Innenkreis aufweist;
- Figur 5: eine Variante der Ausführungsform gemäß Figur 4, bei der ein Kaltwassersatz im Außenkreis angeordnet ist;
- Figur 6: ein Hybridkühlgerät für den Dachaufbau, bei dem ein Kaltwassersatz im Außenkreis angeordnet ist;
- Figur 7: eine Variante des Kühlgeräts gemäß Figur 6, bei der ein Kaltwassersatz im Außenkreis angeordnet ist; und
- Figur 8: ein Hybridkühlgerät, bei dem der aktive Kühlkreislauf über Bypässe wahlweise passiv geschaltet werden kann.

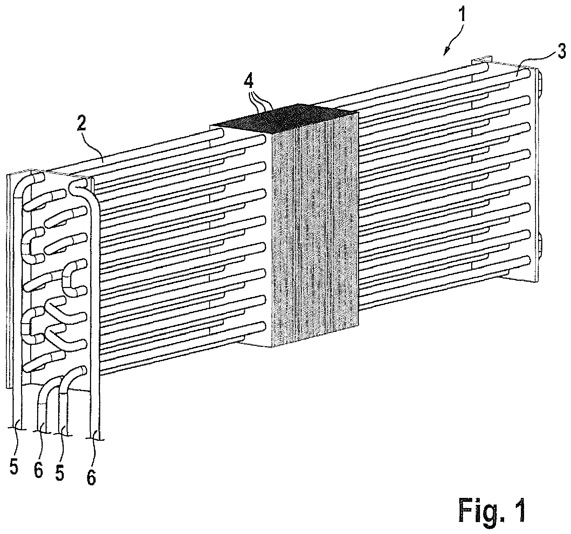

Der Wärmetauscher 1 gemäß Figur 1 weist ein erstes Leitungssystem 2, in dem ein erstes Kühlmittel geführt ist, und ein zweites Leitungssystem 3, in dem ein zweites Kühlmittel geführt ist, auf. Die Leitungssysteme 2, 3 sind jeweils aus parallelen Rohrbahnen zusammengesetzt, die sich zwischen zwei Längsenden des Wärmetauschers 1 erstrecken. An den Längsenden sind die parallelen Rohrleitungen derart miteinander verbunden, dass das Kühlmittel zwischen einem jeweiligen Kühlmittelvorlauf 5 und einem Kühlmittelrücklauf 6 geführt ist. Der in Figur 1 dargestellte Wärmetauscher 1 ist darauf ausgelegt, durch seine in der Darstellung vertikalen Längsseiten hindurch von einem Gas, beispielsweise Luft, durchströmt zu werden. Der Wärmetauscher 1 weist eine Mehrzahl Lamellen 4 auf, wobei benachbarte Lamellen jeweils zwischen sich einen Luftströmungskanal durch den Wärmetauscher hindurch ausbilden. Darüber hinaus haben die Lamellen 4, welche auch entsprechend eines Plattenwärmetauschers als Platten ausgebildet sein können, die Aufgabe, das erste und das zweite Leitungssystem 2, 3 für den Wärmeaustausch thermisch miteinander zu koppeln. Bei der zuvor beschriebenen Strömungsrichtung der den Wärmetauscher 1 durchströmenden Luft sind das erste und das zweite Leitungssystem 2, 3 in Luftströmungsrichtung hintereinander angeordnet. Ist das erste Leitungssystem 2 Bestandteil eines passiven Kühlkreislaufes und das zweite Leitungssystem 3 Bestandteil eines aktiven Kühlkreislaufes, und ist darüber hinaus vorgesehen, dass die Kühlung der den Wärmetauscher 1 durchströmenden Luft bevorzugt über den passiven Kühlprozess erfolgt, kann vorgesehen sein, dass der aktive Kühlprozess nur dann aktiviert wird, wenn die von dem passiven Kühlkreislauf bereitgestellte Kühlleistung nicht ausreicht. Da die beiden Kühlkreisläufe unabhängig voneinander realisiert sind, ist es für das Zuschalten des aktiven Kühlkreislaufes nicht notwendig, dass der passive Kühlkreislauf unterbrochen oder gar vollständig deaktiviert wird. Wenn der aktive Kühlkreislauf deaktiviert ist und die Kühlung somit über den passiven Kühlkreislauf erfolgen soll, dienen die Rohrleitungen des Leitungssystems des aktiven Kühlkreislaufes in dem ersten Wärmetauscher 1 aufgrund der mit Hilfe der Lamellen 4 realisierten Wärmekopplung dazu, die Kühlleistung des Leitungssystems des passiven Kühlkreislaufes zu erhöhen. Selbst wenn der aktive Kühlkreislauf somit deaktiviert ist, ist dessen Leitungssystem in dem Wärmetauscher 1 nicht nutzlos. Vielmehr dient dieses in diesem Fall zur Erhöhung des Wirkungsgrades des passiven Kühlkreislaufes. Wenn beide Kühlkreisläufe aktiviert sind, erfolgt ebenfalls ein Wärmetransport zwischen dem ersten und dem zweiten Leitungssystem 2, 3 entsprechend einem sich einstellenden Temperaturgradienten, wodurch Wärme- oder Kältespitzen innerhalb des Wärmetauschers 1 vermieden werden, so dass wiederum eine Erhöhung des Wirkungsgrades des Wärmetauschers erreicht wird.

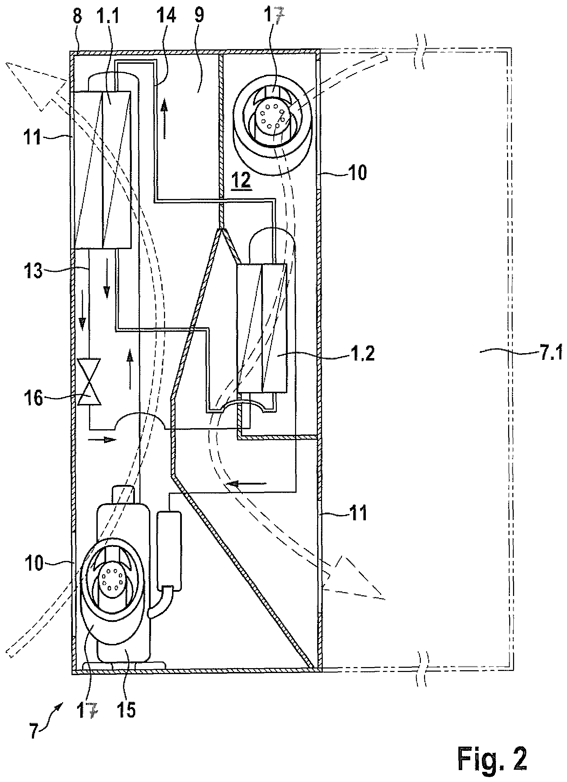

Die Figur 2 zeigt einen Schaltschrank 7, bei dem das Kühlgerät 8 als ein Wandkühlgerät ausgebildet ist. Der Schaltschrank 7 umfasst einen Schaltschrankinnenraum 7.1, wobei an einer Außenwand des Schaltschranks 7 das Kühlgerät 8 angesetzt ist und wobei der Innenraum 7.1 des Schaltschranks 7 über einen Lufteinlass 10 und einen Luftauslass 11 mit dem zweiten Luftgang 12 des Kühlgeräts 8 fluidisch in Verbindung steht. Die in dem Schaltschrank 7.1 aufgenommene Luft wird mit Hilfe des Lüfters 17 durch den Luftgang 12 transportiert. In dem zweiten Luftgang 12 ist ein zweiter erfindungsgemäßer Wärmetauscher 1.2 gemäß Figur 1 angeordnet. Fluidisch abgetrennt von dem zweiten Luftgang 12 weist das Kühlgerät 8 einen ersten Luftgang 9 auf, welcher über einen Lufteinlass 10 und einen Luftauslass 11 mit der Umgebung des Schaltschranks 7 fluidisch in Verbindung steht. Wiederum dient ein Lüfter 17 dazu, Umgebungsluft über den Einlass 10 in den ersten Luftgang 9 des Kühlgeräts 8 zu transportieren. In dem ersten Luftgang 9 ist ein erster erfindungsgemäßer Wärmetauscher 1.1 gemäß Figur 1 angeordnet, der von der durch den ersten Luftgang 9 geführten Luft durchströmt wird. Die Wärmetauscher 1.1, 1.2 stehen derart fluidisch miteinander in Verbindung, dass das erste Leitungssystem 2 des ersten Wärmetauschers 1.1 mit dem ersten Leitungssystem 2 des zweiten Wärmetauschers 1.2 einen ersten geschlossenen Kühlmittelkreislauf 13 und das zweite Leitungssystem 3 des ersten Wärmetauschers 1.1 mit dem zweiten Leitungssystem 3 des zweiten Wärmetauschers 1.2 einen zweiten geschlossenen Kühlmittelkreislauf 14 bildet.

Der erste geschlossene Kühlmittelkreislauf 13 ist bei der Ausführungsform gemäß Figur 2 ein Verdichter getriebener Kühlmittelkreislauf mit einem Verdichter 15 und einem Expansionsventil 16. Demzufolge hat der erste Wärmetauscher 1.1 soweit er den ersten geschlossenen Kühlmittelkreislauf 13 betrifft, die Funktion eines Kondensators und der zweite Wärmetauscher 1.2, soweit er den ersten geschlossenen Kühlmittelkreislauf 13 betrifft, die Funktion eines Verdampfers.

Der zweite geschlossene Kühlmittelkreislauf 14 bildet einen passiven Kühlkreislauf. Dazu ist der erste Wärmetauscher 1.1 oberhalb des zweiten Wärmetauschers 1.2 angeordnet. Der zweite geschlossene Kühlmittelkreislauf 14 ist zumindest teilweise mit einem Kühlmittel gefüllt. Das flüssige Kühlmittel lagert sich schwerkraftbedingt im unteren Bereich des zweiten geschlossenen Kühlmittelkreislaufes 14 ab. Dort ist gerade der zweite Wärmetauscher 1.2 angeordnet. Der zweite Wärmetauscher 1.2 wird von der durch den zweiten Luftgang 12 transportierten warmen Schaltschrankluft durchströmt. Dabei erwärmt sich das Kühlmittel des zweiten geschlossenen Kühlmittelkreislaufes 14, woraufhin dieses zumindest teilweise verdampft. Das verdampfende Kühlmittel steigt in den ersten Wärmetauscher 1.1 auf. Dieser wird von der kühlen Umgebungsluft des Schaltschranks 7, welche durch den ersten Luftgang 9 mit Hilfe des Lüfters 17 transportiert wird, abgekühlt, woraufhin das gasförmige Kühlmittel in dem ersten Wärmetauscher 1.1 kondensiert. Das kondensierte Kühlmittel wandert schwerkraftgetrieben aus dem ersten Wärmetauscher 1.1 zurück in den tiefer gelegenen zweiten Wärmetauscher 1.2 und kann dort erneut verdampfen und in den zweiten Wärmetauscher 1.2 aufsteigen.

Das Kühlgerät 8 gemäß Figur 2 kann somit wahlweise in drei verschiedenen Kühlmodi betrieben werden, nämlich ausschließlich aktiv, ausschließlich passiv, oder hybrid, wobei im Hybridbetrieb insbesondere vorgesehen sein kann, dass der passive Kühlprozess permanent betrieben wird, während der aktive Kühlprozess dazu dient, die mit Hilfe des passiven Kühlprozesses bereitgestellte Kühlleistung soweit zu ergänzen, dass in Summe mindestens die geforderte Kühlleistung zur Verfügung gestellt wird.

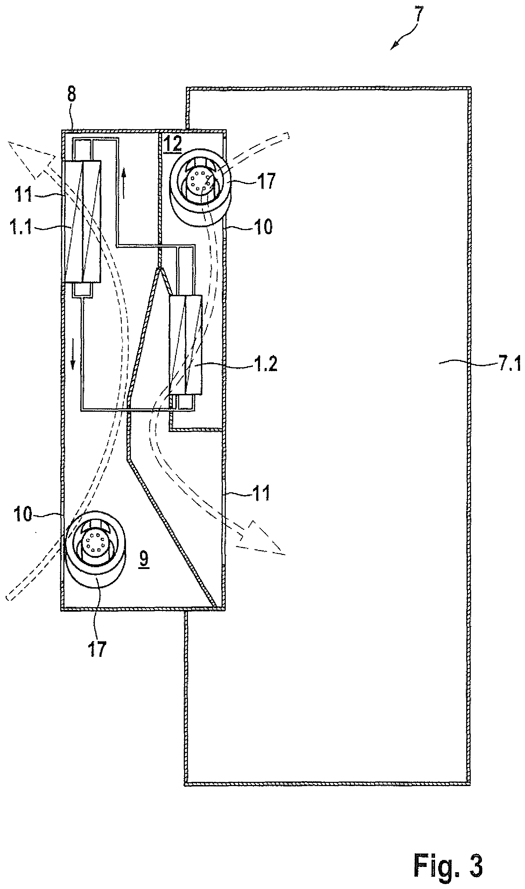

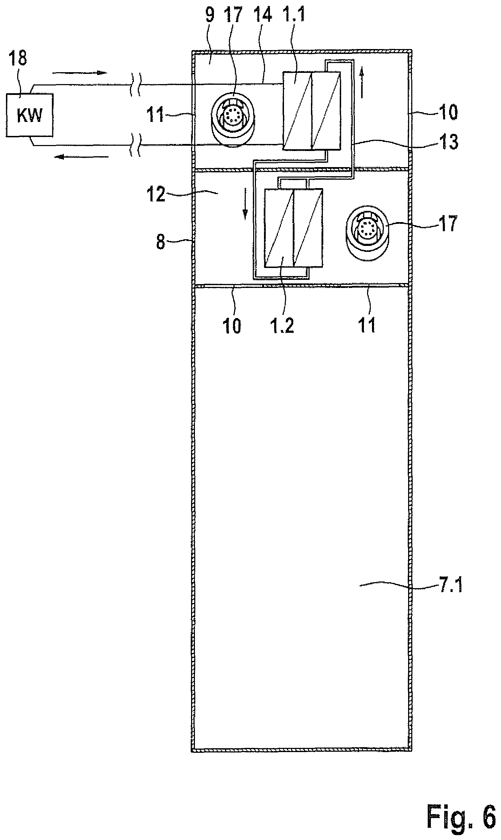

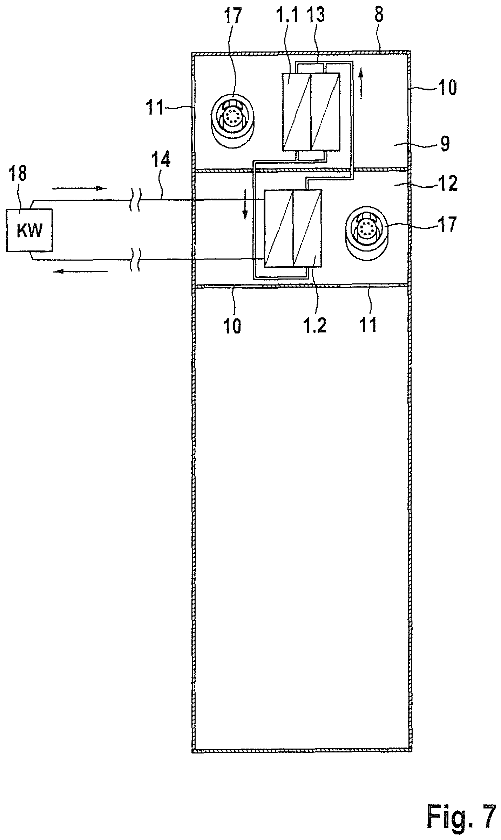

In den Figuren 3 bis 7 ist dargestellt, dass im Wesentlichen ein und derselbe Kühlgerätaufbau dazu dienen kann, eine ganze Vielfalt von unterschiedlichen Kühlprozessen zu realisieren. Dabei betreffen die Ausführungsformen gemäß den Figuren 3 bis 5 Wandkühlgeräte und die Ausführungsformen gemäß den Figuren 6 und 7 Kühlgeräte, die als Dachaufbauten ausgebildet sind.

Das Kühlgerät 8 gemäß Figur 3, das nicht Teil der Erfindung ist, weist zwei erfindungsgemäße Wärmetauscher 1.1, 1.2 auf, bei denen jeweils das erste und das zweite Leitungssystem 2, 3 derart in Reihe geschaltet sind, dass der jeweilige Wärmetauscher 1.1, 1.2 jeweils einen Anschluss für einen Kühlmittelvorlauf und einen Anschluss für einen Kühlmittelrücklauf aufweist. Der Kühlkreislauf weist keine aktiven Komponenten wie Kompressoren, Verdichter oder Pumpen auf und basiert somit auf dem bereits zuvor beschriebenen Heat-Pipe-Prinzip. Dazu ist insbesondere notwendig, dass der erste Wärmetauscher 1.1 zumindest teilweise oberhalb des zweiten Wärmetauschers 1.2 angeordnet ist.

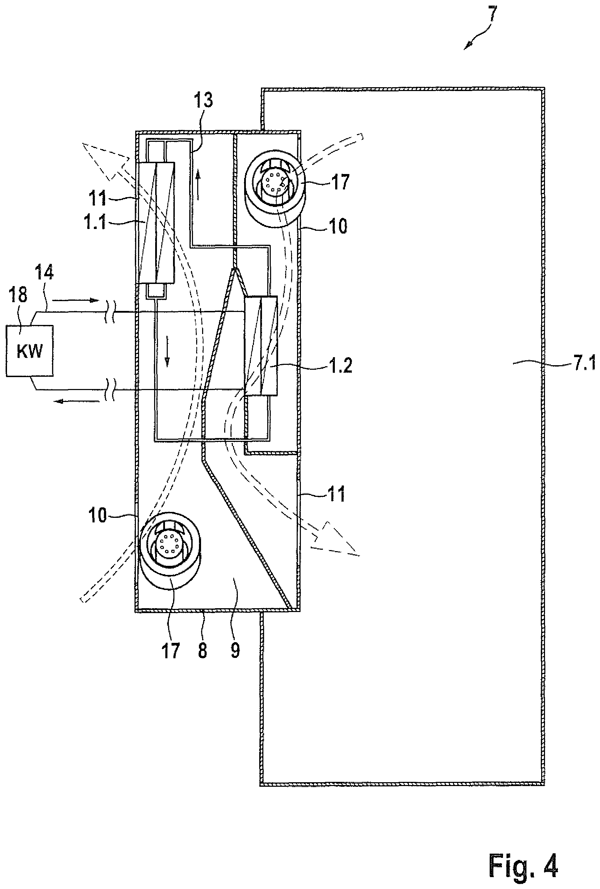

Wie Figur 4 zeigt, kann im Wesentlichen derselbe Aufbau des Kühlgeräts 8 dazu verwendet werden, einen hybriden Kühlprozess zu realisieren, bei dem das erste und das zweite Leitungssystem 2, 3 des ersten Wärmetauschers 1.1 in Reihe geschaltet sind, und wobei diese mit einem der beiden Leitungssysteme 2, 3 des zweiten Wärmetauschers 1.2 einen passiven, geschlossenen Kühlkreislauf 13 bilden. Das verbleibende Leitungssystem 2, 3 des zweiten Wärmetauschers 1.2 bildet mit einer Kaltwasserquelle 18 einen zweiten geschlossenen Kühlmittelkreislauf 14. Die Kaltwasserquelle 18 stellt gekühltes Wasser bereit, welches durch den Wärmetauscher 1.2 zirkuliert wird und ist nicht Bestandteil des Kühlgeräts 8.. Dieser zusätzliche aktive Kühlmittelkreislauf 14 kann somit dazu dienen, entweder bei hohen Verlustleistungen der in dem Schaltschrankinnenraum 7.1 aufgenommenen Komponenten oder bei hohen Umgebungstemperaturen des Schaltschrankes 7 eine zusätzliche Kühlleistung zur Verfügung zu stellen, welche die mit Hilfe des passiven Kühlkreislaufes 13 bereitgestellte Kühlleistung soweit ergänzt, dass in Summe eine ausreichende Schaltschrankkühlung zur Verfügung gestellt wird.

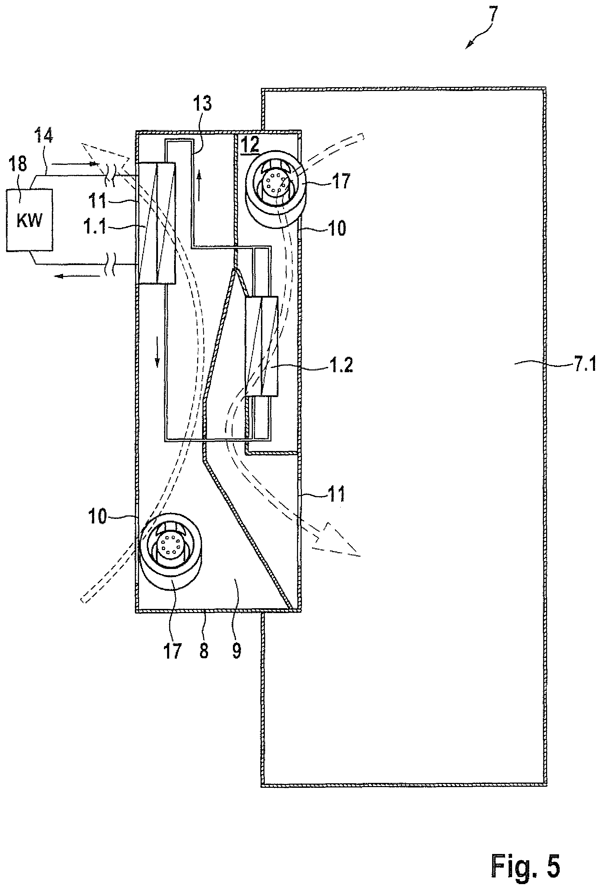

Insbesondere bei hohen Umgebungstemperaturen kann es entsprechend dem Aufbau gemäß Figur 5 zweckmäßig sein, den zusätzlichen aktiven Kühlmittelkreislauf 14 mit Hilfe des in den zweiten Luftgang 9 integrierten Wärmetauschers 1.1 zu realisieren.

Die Figuren 6 und 7 zeigen, dass analog zu den Figuren 3 und 4 Kühlgeräte 8 für den Dachaufbau realisiert werden können, welche die erfindungsgemäße hohe Variabilität aufweisen. Auch bei Kühlgeräten, die als Dachaufbauten realisiert sind, ist es dem Anwender freigestellt, den aktiven Kühlmittelkreislauf 14 neben dem passiven Kühlmittelkreislauf 13 entweder im Außenkreis über den ersten Wärmetauscher 1.1 (siehe Figur 6), oder im Innenkreis über den zweiten Wärmetauscher 1.2 (siehe Figur 7) zu realisieren.

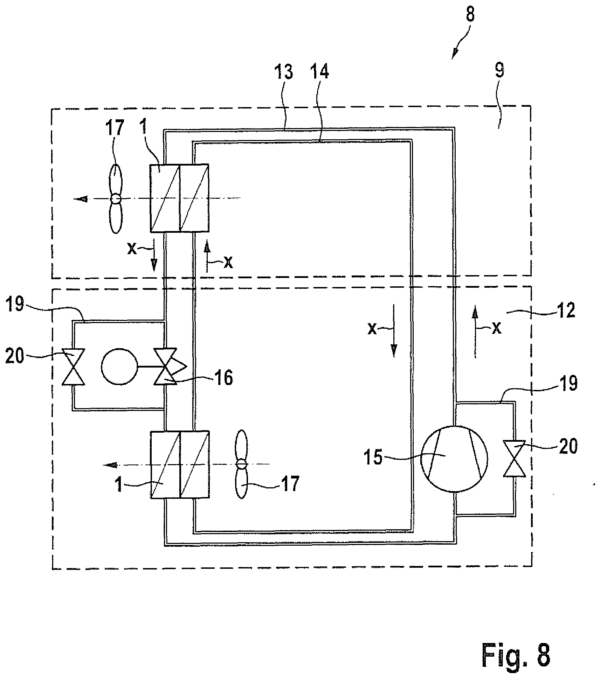

Die Figur 8 beschreibt eine alternative Ausführungsform des erfindungsgemäßen Hybridkühlgeräts 8, mit einem ersten und einem zweiten erfindungsgemäßen Wärmetauscher 1, die einen ersten geschlossenen Kühlmittelkreislauf 13 und einen zweiten geschlossenen Kühlmittelkreislauf 14 thermisch miteinander koppeln. Der erste geschlossene Kühlmittelkreislauf 13 ist ein aktiver Kühlmittelkreislauf, der in Kühlmittelströmungsrichtung hintereinander einen Verdichter 15, einen Verflüssiger in Form des oberen Wärmetauschers 1, ein Expansionsmittel 16 und einen Verdampfer in Form des unteren Wärmetauschers 1 aufweist. Der Verdichter 15 und das Expansionsmittel 16 sind über eine Bypassleitung 19, die jeweils ein Ventil 20 aufweist, überbrückt. In der Schließstellung der Ventile 20 kann der erste geschlossene Kühlmittelkreislauf 13 aktiv betrieben werden. Sind die Ventile 20 geöffnet, bilden die Wärmetauscher 1 eine Heatpipe und somit einen passiven Kühlmittelkreislauf. Die beiden Kühlmittelkreisläufe 13, 14 sind derart zueinander angeordnet, dass die jeweiligen Kältemittel in entgegengesetzter Richtung zueinander transportiert werden, wenn der erste Kühlmittelkreislauf 13 aktiv betrieben wird. In dem zweiten Kühlmittelkreislauf 14 ist ein zweites Kühlmittel zwischen dem Verdampfer und dem Verflüssiger geführt. Der Verflüssiger und der Verdampfer sind jeweils derart ausgestaltet, dass die beiden Kühlmittelkreisläufe 13, 14 über den Verdampfer und den Verflüssiger thermisch miteinander gekoppelt sind. Der Verlüssiger ist um einen vertikalen Abstand oberhalb von dem Verlüssiger angeordnet. Der Verflüssiger ist in einem von einem ersten Teilgehäuse des Kühlgeräts gebildeten ersten Luftgang 9 des Kühlgeräts 8 und der Verdampfer sowie der Verdichter 15 und das Expansionsmittel 16 sind in einem von einem zweiten Teilgehäuse des Kühlgeräts gebildeten zweiten Luftgang 12 angeordnet. Durch den ersten Luftgang 9 und insbesondere den Verflüssiger wird Umgebungsluft des Schaltschranks mit Hilfe eines Lüfters 17 transportiert. Durch den zweiten Luftgang 12 und insbesondere den Verdampfer wird erwärmte Luft aus dem Schaltschrankinnern mit Hilfe eines weiteren Lüfters 17 transportiert. Die Ventile 20 in den Bypassleitungen 19 sind vorzugsweise elektrisch ansteuerbare Magnetventile.

Das zweite Kühlmittel in dem zweiten Kühlmittelkreislauf 14 wird über die warme Schaltschrankluft, welche durch den zweiten Luftgang 12 transportiert wird, erwärmt, woraufhin dieses zumindest teilweise verdampft oder seine Dichte zumindest insoweit verringert, dass es entlang dem zweiten Kühlmittelkreislauf 14 von dem Verdampfer in den Verflüssiger transportiert wird. Der Verflüssiger wird von kühler Umgebungsluft des Schaltsschranks umströmt. Dadurch kondensiert bzw. verdichtet sich das Kühlmittel derart, dass es entlang dem Kühlmittelkreislauf 14 zurück in den Verdampfer fließt, um dort erneut von der warmen Schaltschrankluft erwärmt zu werden. Befindet sich der erste Kühlmittelkreislauf 13 ebenso im passiven Betriebsmodus, kann auch in diesem das Kältemittel in der zuvor mit Bezug auf den zweiten Kühlmittelkreislauf 14 beschriebenen Weise zwischen dem Verdampfer und dem Verflüssiger zirkulieren. In diesem Fall ist die Transportrichtung des ersten Kühlmittels in dem ersten Kühlmittelkreislauf 13 entgegen der eingezeichneten Strömungsrichtung x. Die eingezeichnete Strömungsrichtung x des ersten Kühlmittels in dem ersten Kühlmittelkreislauf 13 entspricht derjenigen, welche sich bei dem aktiven Betrieb des ersten Kühlmittelkreislaufes 13 einstellt. In diesem Fall bewegen sich die Kühlmittel in dem ersten und dem zweiten Kühlmittelkreislauf 13, 14 somit in entgegengesetzter Richtung, wodurch der Wirkungsgrad des Verdampfers bzw. des Verflüssigers weiter verbessert wird.

## Patentansprüche

1. Kühlanordnung mit einem Schaltschrank (7) und einem Kühlgerät (8), das einen ersten und einen zweiten Wärmetauscher (1.1, 1.2) für die Schaltschrankkühlung aufweist, wobei der erste und der zweite Wärmetauscher (1.1, 1.2) jeweils ein erstes Leitungssystem (2) für ein erstes Kühlmittel und mindestens ein von dem ersten Leitungssystem (2) fluidisch abgetrennten zweites Leitungssystem (3) für ein zweites Kühlmittel aufweisen, wobei das erste und das zweite Leitungssystem (2, 3) thermisch miteinander gekoppelt sind, wobei der erste und der zweite Wärmetauscher (1.1, 1.2) jeweils eine Mehrzahl Lamellen (4) aufweisen, wobei benachbarte Lamellen (4) zwischen sich einen Luftströmungskanal jeweils durch den ersten und den zweiten Wärmetauscher (1.1, 1.2) ausbilden, und wobei das erste und das zweite Leitungssystem (2, 3) über die Mehrzahl Lamellen (4) thermisch miteinander gekoppelt sind, wobei der erste Wärmetauscher (1.1) in einem ersten Luftgang (9) mit einem ersten Lufteinlass (10) und einem ersten Luftauslass (11), die zur Umgebung des Schaltschranks (7) hin geöffnet sind, und der zweite Wärmetauscher (1.2) in einem zweiten Luftgang (12) mit einem zweiten Lufteinlass (10) und einem zweiten Luftauslass (11), die zu einem Innenraum (7.1) des Schaltschranks (7) hin geöffnet sind, angeordnet ist, wobei das erste Leitungssystem (2) des ersten Wärmetauschers (1.1) mit dem ersten Leitungssystem (2) des zweiten Wärmetauschers (1.2) einen ersten geschlossenen Kühlmittelkreislauf (13) und das zweite Leitungssystem des ersten Wärmetauschers (1.1) mit dem zweiten Leitungssystem (3) des zweiten Wärmetauschers (1.2) einen zweiten geschlossenen Kühlmittelkreislauf (14) bildet, wobei einer der Kühlmittelkreisläufe ein aktiver Kühlkreislauf und der andere Kühlmittelkreislauf ein passiver Kühlkreislauf ist.

2. Kühlanordnung nach Anspruch 1, bei dem die Lamellen (4) parallel zueinander ausgerichtet sind.

3. Kühlanordnung nach Anspruch 1 oder 2, bei dem das erste und das zweite Leitungssystem (2, 3) in Luftströmungsrichtung durch den Wärmetauscher (1) unmittelbar oder mittelbar hintereinander angeordnet sind.

4. Kühlanordnung nach einem der vorangegangenen Ansprüche, bei dem das erste und das zweite Leitungssystem (2, 3) jeweils einen Anschluss für einen Kühlmittelvorlauf (5) und einen Anschluss für einen Kühlmittelrücklauf (6) aufweist.

5. Kühlanordnung nach einem der vorangegangenen Ansprüche, bei dem zumindest eines der Leitungssysteme (2, 3) mäanderförmig geführt ist, so dass die Ausbildung von Siphons verhindert wird.

6. Kühlanordnung nach Anspruch 1, bei der der erste Wärmetauscher (1.1) zumindest teilweise oberhalb des zweiten Wärmetauschers (1.2) angeordnet ist.

7. Kühlanordnung nach Anspruch 1 oder 6, wobei der erste Wärmetauscher (1.1) in dem ersten Luftgang (9) und der zweite Wärmetauscher (1.2) in dem zweiten Luftgang (12) derart angeordnet sind, dass das Leitungssystem des passiven Kühlmittelkreislaufes in Luftströmungsrichtung vor dem Leitungssystem des aktiven Kühlmittelkreislaufes angeordnet ist.

8. Kühlanordnung mit einem Schaltschrank (7) und einem Kühlgerät (8), das einen ersten und einen zweiten Wärmetauscher (1.1, 1.2) für die Schaltschrankkühlung aufweist, wobei der erste und der zweite Wärmetauscher (1.1, 1.2) jeweils ein erstes Leitungssystem (2) für ein Kühlmittel und mit mindestens ein von dem ersten Leitungssystem (2) fluidisch abgetrenntes zweites Leitungssystem (3) für ein Kühlmittel aufweisen, wobei das erste und das zweite Leitungssystem (2, 3) thermisch miteinander gekoppelt sind, wobei der erste und der zweite Wärmetauscher (1.1, 1.2) jeweils eine Mehrzahl Lamellen (4) aufweisen, wobei benachbarte Lamellen (4) zwischen sich einen Luftströmungskanal jeweils durch den ersten und den zweiten Wärmetauscher (1.1, 1.2) ausbilden, und wobei das erste und das zweite Leitungssystem (2, 3) über die Mehrzahl Lamellen (4) thermisch miteinander gekoppelt sind, wobei der erste Wärmetauscher (1.1) in einem ersten Luftgang (9) mit einem ersten Lufteinlass (10) und einem ersten Luftauslass (11), die zur Umgebung des Schaltschranks (7) hin geöffnet sind, und der zweite Wärmetauscher (1.2) in einem zweiten Luftgang (12) mit einem zweiten Lufteinlass (10) und einem zweiten Luftauslass (11), die zu einem Innenraum (7.1) des Schaltschranks (7) hin geöffnet sind, angeordnet ist, bei dem entweder
1. das erste und das zweite Leitungssystem (2, 3) des ersten Wärmetauschers (1.1) derart in Reihe geschaltet sind, dass der erste Wärmetauscher (1.1) einen Anschluss für einen Kühlmittelvorlauf und einen Anschluss für einen Kühlmittelrücklauf aufweist, wobei die in Reihe geschalteten Leitungssysteme (2, 3) entweder mit dem ersten oder dem zweiten Leitungssystem (2, 3) des zweiten Wärmetauschers (1.2) einen geschlossenen Kühlmittelkreislauf mit einem ersten Kühlmittel bilden, und wobei das Leitungssystem (2, 3) des zweiten Wärmetauschers (1.2), welches nicht Bestandteil des geschlossenen Kühlmittelkreislaufes ist, von einem zweiten Kühlmittel durchströmt ist; oder
2. das erste und das zweite Leitungssystem (2, 3) des zweiten Wärmetauschers (1.2) derart in Reihe geschaltet sind, dass der zweite Wärmetauscher (1.2) einen Anschluss für einen Kühlmittelvorlauf und einen Anschluss für einen Kühlmittelrücklauf aufweist, wobei die in Reihe geschalteten Leitungssysteme (2, 3) entweder mit dem ersten oder dem zweiten Leitungssystem (2, 3) des ersten Wärmetauschers (1.1) einen geschlossenen Kühlmittelkreislauf mit einem ersten Kühlmittel bilden, und wobei das Leitungssystem (2, 3) des ersten Wärmetauschers (1.2), welches nicht Bestandteil des geschlossenen Kühlmittelkreislaufes ist, von einem zweiten Kühlmittel durchströmt ist,
wobei der geschlossene Kühlmittelkreislauf ein passiver und das von dem zweiten Kühlmittel durchströmte Leitungssystem ein aktiver, vorzugsweise Pumpen- oder Verdichter getriebener Kühlkreislauf ist.

9. Kühlanordnung nach Anspruch 8, bei der der erste Wärmetauscher (1.1) zumindest teilweise oberhalb des zweiten Wärmetauschers (1.2) angeordnet ist

10. Kühlanordnung nach Anspruch 9, bei der der Wärmetauscher (1.1, 1.2) der das von dem zweiten Kühlmittel durchströmte Leitungssystem (2, 3) aufweist, ein Verdampfer oder ein Luft-Wasser-Wärmetauscher des aktiven Kühlkreislaufes und zugleich, wenn das von dem Kühlmittel durchströmte Leitungssystem (2, 3) Bestandteil des ersten Wärmetauschers (1.1) ist, ein Verflüssiger des passiven Kühlkreislaufes, oder, wenn das von dem Kühlmittel durchströmte Leitungssystem (2, 3) Bestandteil des zweiten Wärmetauschers (1.2) ist, ein Verdampfer des passiven Kühlkreislaufes ist.

11. Kühlanordnung nach Anspruch 1 oder 6, wobei ein Verdichter (15) und ein Expansionsmittel (16) des aktiven Kühlmittelkreislaufes jeweils entweder über eine wahlweise öffnen- und verschließbare Bypassleitung (19) überbrückt sind, oder einen Zustand einnehmen können, in welchem ein Kühlmittel sie mit einem geringeren oder ohne Druckverlust passieren kann.

## Claims

1. A cooling arrangement with a switch cabinet (7) and with a cooling apparatus (8), which has a first and second heat exchanger (1.1, 1.2) for cooling the switch cabinet, with a first line system (2) for a first coolant and with at least one second line system (3) for a second coolant, separated fluidically from the first line system (2), the first and the second line system (2, 3) being coupled thermally to one another, wherein the heat exchanger (1) comprises a plurality of lamellae (4), adjacent lamellae (4) forming between them an air flow duct through the heat exchanger (1), and the first and second line system (2, 3) being coupled thermally to one another via the plurality of lamellae (4), **characterized in that** the first heat exchanger (1.1) being disposed in a first air passage (9) with a first air inlet (10) and with a first air outlet (11), which are open to the surroundings of the switch cabinet (7) and the second heat exchanger (1.2) being disposed in a second air passage (12) with a second air inlet (10) and with a second air outlet (11), which are open to an interior (7.1) of the switch cabinet (7), the first line system (2) of the first heat exchanger (1.1) forming with the first line system (2) of the second heat exchanger (1.2) a first closed coolant circuit (13), and the second line system of the first heat exchanger (1.1) forming with the second line system (3) of the second heat exchanger (1.2) a second closed coolant circuit (11), one of the cooling circuits being an active coolant circuit and the other coolant circuit being a passive coolant circuit.

2. The cooling arrangement according to claim 1, wherein the lamellae (4) are oriented parallel to one another.

3. The cooling arrangement according to claim 1 or 2, wherein the first and second line system (2,3) are disposed directly or indirectly one behind the other in the air flow direction through the heat exchanger (1).

4. The cooling arrangement according to one of the preceding claims, wherein the first and second line system (2, 3) each have a connection for a coolant forward flow (5) and a connection for a coolant return flow (6).

5. The cooling arrangement according to one of the preceding claims, wherein at least one of the line systems (2, 3) is routed in a meander-shaped manner, so that the formation of siphons is prevented.

6. The cooling arrangement according to claim 1, wherein the first heat exchanger (1.1) is disposed at least partially above the second heat exchanger (1.2).

7. The cooling arrangement according to claim 1 or 6, wherein the first heat exchanger (1.1) is disposed in the first air passage (9) and the second heat exchanger (1.2) is disposed in the second air passage (12), in such a way that the line system of the passive coolant circuit is disposed upstream of the line system of the active coolant circuit in the air flow direction.

8. A cooling arrangement with a switch cabinet (7) and with a cooling apparatus (8) which has a first and second heat exchanger (1.1, 1.2) for cooling the switch cabinet, with a first line system (2) for a first coolant and with at least one second line system (3) for a second coolant, separated fluidically from the first line system (2), the first and the second line system (2, 3) being coupled thermally to one another, wherein the heat exchanger (1) comprises a plurality of lamellae (4), adjacent lamellae (4) forming between them an air flow duct through the heat exchanger (1), and the first and second line system (2,3) being coupled thermally to one another via the plurality of lamellae (4), **characterized in that** the first heat exchanger (1.1) being disposed in a first air passage (9) with a first air inlet (10) and with a first air outlet (11), which are open to the surroundings of the switch cabinet (7) and the second heat exchanger (1.2) being disposed in a second air passage (12) with a second air inlet (10) and with a second air outlet (11), which are open to an interior (7.1) of the switch cabinet (7), in which either
1. the first and the second line system (2,3) of the first heat exchanger (1.1) are connected in series, the series-connected line systems (2, 3) forming either with the first or with the second line system (2, 3) of the second heat exchanger (1.2) a closed coolant circuit, and a coolant flowing though that line system (2, 3) of the second heat exchanger (1.2) which is not an integral part of the closed coolant circuit; or
2. the first and second line system (2, 3) of the second heat exchanger (1.2) are connected in series, the series-connected line systems (2, 3) forming either with the first or with the second line system (2, 3) of the first heat exchanger (1.1) a closed coolant circuit, and a coolant flowing through that line system (2, 3) of the first heat exchanger (1.1) which is not an integral part of the closed coolant circuit;
the closed coolant circuit being a passive coolant circuit and the line system through which the coolant flows being an active, preferably pump or compressor-driven, cooling circuit.

9. The cooling arrangement according to claim 8, wherein the first heat exchanger (1.1) is disposed at least partially above the second heat exchanger (1.2).

10. The cooling arrangement according to claim 9, wherein the heat exchanger (1.1, 1.2) which has the line system (2, 3) through which the coolant flows is an evaporator or an air/water heat exchanger of the active cooling circuit and at the same time, when the line system (2, 3) through which the coolant flows is an integral part of the first heat exchanger (1.1), is a condenser of the passive cooling circuit or, when the line system (2, 3) through which the coolant flows is an integral part of the second heat exchanger (1.2), is an evaporator of the passive cooling circuit.

11. The cooling arrangement according to claim 1 or 6, wherein a compressor (15) and an expansion means (16) of the active coolant circuit each either are bridged via a selectively openable and closable bypass line (19) or are capable of assuming a state in which a coolant can pass through them with insignificant or essentially without pressure loss.

## Revendications

1. Dispositif de refroidissement avec une armoire de commande (7) et un appareil de refroidissement (8), qui comprend un premier et un deuxième échangeurs thermiques (1.1, 1.2) pour le refroidissement de l'armoire de commande, le premier et le deuxième échangeurs thermiques (1.1, 1.2) comprenant chacun un premier système de conduites (2) pour un premier fluide de refroidissement et au moins un deuxième système de conduites (3) pour un deuxième fluide de refroidissement, séparé fluidiquement du premier système de conduites (2), le premier et le deuxième systèmes de conduites (2, 3) étant couplés thermiquement entre eux, le premier et le deuxième échangeurs thermiques (1.1, 1.2) comprenant chacun une pluralité de lamelles (4), des lamelles (4) adjacentes formant entre elles un canal d'écoulement d'air à travers le premier et le deuxième échangeurs thermiques (1.1, 1.2) et le premier et le deuxième systèmes de conduites (2, 3) étant couplés thermiquement entre eux par l'intermédiaire de la pluralité de lamelles (4), le premier échangeur thermique (1.1) étant disposé dans un premier passage d'air (9), avec une première entrée d'air (10) et une première sortie d'air (11), qui sont ouvertes en direction de l'environnement de l'armoire de commande (7), et le deuxième échangeur thermique (1.2) étant disposé dans un deuxième passage d'air (12), avec une deuxième entrée d'air (10) et une deuxième sortie d'air (11), qui sont ouvertes en direction d'un espace intérieur (7.1) de l'armoire de commande (7), le premier système de conduites (2) du premier échangeur thermique (1.1) formant, avec le premier système de conduites (2) du deuxième échangeur thermique (1.2), un premier circuit de fluide de refroidissement fermé (13) et le deuxième système de conduites du premier échangeur thermique (1.1) formant, avec le deuxième système de conduites (3) du deuxième échangeur thermique (1.2), un deuxième circuit de fluide de refroidissement fermé (14), un des circuits de fluide de refroidissement étant un circuit de refroidissement actif et l'autre circuit de fluide de refroidissement étant un circuit de refroidissement passif.

2. Dispositif de refroidissement selon la revendication 1, dans lequel les lamelles (4) sont orientées parallèlement entre elles.

3. Dispositif de refroidissement selon la revendication 1 ou 2, dans lequel le premier et le deuxième systèmes de conduites (2, 3) sont disposés, dans la direction d'écoulement de l'air à travers l'échangeur thermique (1), directement ou indirectement l'un derrière l'autre.

4. Dispositif de refroidissement selon l'une des revendications précédentes, dans lequel le premier et le deuxième systèmes de conduites (2, 3) comprennent chacun un raccordement pour un aller de fluide de refroidissement (5) et un raccordement pour un retour de fluide de refroidissement (6).

5. Dispositif de refroidissement selon l'une des revendications précédentes, dans lequel au moins un des systèmes de conduites (2, 3) présente une forme sinueuse de façon à empêcher la formation de siphons.

6. Dispositif de refroidissement selon la revendication 1, dans lequel le premier échangeur thermique (1.1) est disposé au moins partiellement au-dessus du deuxième échangeur thermique (1.2).

7. Dispositif de refroidissement selon la revendication 1 ou 6, le premier échangeur thermique (1.1) étant disposé dans le premier passage d'air (9) et le deuxième échangeur thermique (1.2) étant disposé dans le deuxième passage d'air (12), de façon à ce que le système de conduites du circuit de fluide de refroidissement passif soit disposé, dans la direction d'écoulement de l'air, avant le système de conduites du circuit de fluide de refroidissement actif.

8. Dispositif de refroidissement avec une armoire de commande (7) et un appareil de refroidissement (8), qui comprend un premier et un deuxième échangeurs thermiques (1.1, 1.2) pour le refroidissement de l'armoire de commande, le premier et le deuxième échangeurs thermiques (1.1, 1.2) comprenant chacun un premier système de conduites (2) pour un premier fluide de refroidissement et au moins un deuxième système de conduites (3) pour un deuxième fluide de refroidissement, séparé fluidiquement du premier système de conduites (2), le premier et le deuxième systèmes de conduites (2, 3) étant couplés thermiquement entre eux, le premier et le deuxième échangeurs thermiques (1.1, 1.2) comprenant chacun une pluralité de lamelles (4), des lamelles (4) adjacentes formant entre elles un canal d'écoulement d'air à travers le premier et le deuxième échangeurs thermiques (1.1, 1.2) et le premier et le deuxième systèmes de conduites (2, 3) étant couplés thermiquement entre eux par l'intermédiaire de la pluralité de lamelles (4), le premier échangeur thermique (1.1) étant disposé dans un premier passage d'air (9), avec une première entrée d'air (10) et une première sortie d'air (11), qui sont ouvertes en direction de l'environnement de l'armoire de commande (7), et le deuxième échangeur thermique (1.2) étant disposé dans un deuxième passage d'air (12), avec une deuxième entrée d'air (10) et une deuxième sortie d'air (11), qui sont ouvertes en direction d'un espace intérieur (7.1) de l'armoire de commande (7), dans lequel :
1. soit le premier et le deuxième systèmes de conduites (2, 3) du premier échangeur thermique (1.1) sont branchés en série de façon à ce que le premier échangeur thermique (1.1) comprenne un raccordement pour un aller du fluide de refroidissement et un raccordement pour un retour du fluide de refroidissement, les systèmes de conduites (2, 3) branchés en série formant, soit avec le premier soit avec le deuxième système de conduites (2, 3) du deuxième échangeur thermique (1.2), un circuit de fluide de refroidissement fermé avec un premier fluide de refroidissement, et le système de conduites (2, 3) du deuxième échangeur thermique (1.2), qui ne fait pas partie du circuit de fluide de refroidissement fermé, étant traversé par un deuxième fluide de refroidissement ;
2. soit le premier et le deuxième systèmes de conduites (2, 3) du deuxième échangeur thermique (1.2) sont branchés en série de façon à ce que le deuxième échangeur thermique (1.2) comprenne un raccordement pour un aller du fluide de refroidissement et un raccordement pour un retour du fluide de refroidissement, les systèmes de conduites (2, 3) branchés en série formant, soit avec le premier soit avec le deuxième système de conduites (2, 3) du premier échangeur thermique (1.1), un circuit de fluide de refroidissement fermé avec un premier fluide de refroidissement, et le système de conduites (2, 3) du premier échangeur thermique (1.2), qui ne fait pas partie du circuit de fluide de refroidissement fermé, étant traversé par un deuxième fluide de refroidissement,
le circuit de fluide de refroidissement fermé étant un circuit de refroidissement passif et le système de conduites traversé par le deuxième fluide de refroidissement étant un circuit de refroidissement actif, plus particulièrement entraîné par des pompes ou un compresseur.

9. Dispositif de refroidissement selon la revendication 8, dans lequel le premier échangeur thermique (1.1) est disposé au moins partiellement au-dessus du deuxième échangeur thermique (1.2).

10. Dispositif de refroidissement selon la revendication 9, dans lequel l'échangeur thermique (1.1, 1.2), qui comprend le système de conduites (2, 3) traversé par le deuxième fluide de refroidissement, est un évaporateur ou un échangeur thermique air-eau du circuit de refroidissement actif et simultanément, lorsque le système de conduites (2, 3) traversé par le fluide de refroidissement fait partie du premier échangeur thermique (1.1), un condenseur du circuit de refroidissement passif ou, lorsque le système de conduites (2, 3) fait partie du deuxième échangeur thermique (1.2), un évaporateur du circuit de refroidissement passif.

11. Dispositif de refroidissement selon la revendication 1 ou 6, un compresseur (15) et un moyen d'expansion (16) du circuit de fluide de refroidissement actif étant court-circuités soit par l'intermédiaire d'une conduite de dérivation (19) pouvant être ouverte et fermée, soit pouvant adopter un état dans lequel un fluide de refroidissement peut les traverser avec une faible perte de charge voire sans perte de charge.
